# EUROPÄISCHE PATENTSCHRIFT

(11) **EP 0 915 342 B1**
(45) Veröffentlichungstag und Bekanntmachung des Hinweises auf die Patenterteilung: **03.03.2004**
(21) Anmeldenummer: 98119385.7
(22) Anmeldetag: 14.10.1998
(51) Int. Cl.: G01R 1/073

(54) **Prüfkopf für Mikrostrukturen mit Schnittstelle**
Test head for microstructures with interface
Tête de sonde pour microstructures avec interface

(30) Priorität: 10.11.1997 DE 19749456; 05.11.1997 DE 19748823
(43) Veröffentlichungstag der Anmeldung: 12.05.1999
(73) Patentinhaber: Feinmetall GmbH, 71083 Herrenberg (DE)
(72) Erfinder: Schmid, Rainer, 72124 Pliezhausen (DE); Giringer, Klaus, 71083 Herrenberg (DE); Gauss,Ulrich, 71083 Herrenberg (DE); Deusch, Heinz, 71134 Aidlingen (DE)
(74) Vertreter: Grosse, Rainer, Dipl.-Ing.

(56) Entgegenhaltungen:
- EP-A- 0 068 270
- US-A- 4 423 376
- US-A- 4 783 624
- US-A- 4 963 822
- US-A- 5 123 848

## Beschreibung

Die Erfindung betrifft einen Prüfkopf mit einer Kontaktiervorrichtung zum Kontaktieren von vorzugsweise eng nebeneinander angeordneten Prüfpunkten eines elektrischen Prüflings, gemäß Oberbegriff des Anspruchs 1.

Prüfköpfe der hier angesprochenen Art dienen zum gleichzeitigen Kontaktieren von mehreren, nebeneinander angeordneten Prüfpunkten eines elektrischen Prüflings, beispielsweise eines Halbleiterbauelements. Der Prüfkopf umfaßt mehrere stiftförmige, aus einem elastischen Material bestehende Kontaktelemente, die bei einem Prüfvorgang in Anlage mit jeweils einem zugeordneten Prüfpunkt gebracht werden. Die Kontaktkraft wird dabei durch Ausknicken und/oder Ausfedern der Kontaktelemente senkrecht zu ihrer Längserstreckung beim Aussetzen der Kontaktelemente auf die Prüfpunkte beziehungsweise der Prüfpunkte auf die Kontaktelemente aufgebracht. Die Kontaktelemente sind in Durchgangsöffnungen von zwei voneinander beabstandeten Führungsplatten angeordnet. Aufgrund ihrer Funktion müssen die Kontaktelemente in den Durchgangsöffnungen der Führungsplatten axial beweglich gelagert sein. Um zu verhindern, daß die Kontaktelemente in Bereitschaftsstellung des Prüfkopfs, also beispielsweise zwischen zwei Prüfvorgängen, aus dem Prüfkopf beziehungsweise den Durchgangsöffnungen -der Schwerkraft folgend- herausfallen, ist aus der DE 23 64 786 bekannt, im Endbereich eines Kontaktelements einen Abstützkopf anzubringen, dessen Außenmaße größer sind als die lichte Weite der Durchgangsöffnungen. Aufgrund der durch den Abstützkopf bedingten Vergrößerung des Durchmessers der Kontaktelemente weist das jeweilige Kontaktelement einen erhöhten Platzbedarf auf. Durch den relativ großen Abstand der Kontaktelemente zueinander können auf engstem Raum angeordnete, kleine Prüfpunkte, wie sie beispielsweise bei Prüflingen aus der Halbleitertechnik häufig vorkommen, nicht mehr kontaktiert werden.

US 4 423 376 A offenbart eine Vorrichtung, in der Kontaktelemente in drei Führungsplatten gehalten werden und eine Führungsplatte zum Drehen der Kontaktstifte verwendet wird. Deshalb sind auch die Kontaktstifte so vorgebogen, daß sie sich beim Drehvorgang kaum verschieben. Dies hat zur Folge, daß die Kontaktstifte nicht einfach austauschbar sind.

US 4 783 624 A beschreibt eine Kontaktiervorrichtung, in der die Kontaktelemente in Kapseln durch drei Führungsplatten geführt werden, also nicht reibschlüssig gehalten werden und nicht einfach auszutauschen sind.

EP 0 068 270 A und US 4 963 822 A beschreiben auch eine Halterung von Kontaktstiften in drei Führungsplatten. Dabei sind die Kontaktstifte in einer Führungsplatte fest verankert, so daß sie weder verschiebbar noch einfach austauschbar sind.

Es ist daher Aufgabe der Erfindung, einen Prüfkopf zu schaffen, bei dem die Kontaktelemente eng nebeneinander angeordnet werden können und einfach austauschbar sind.

Zur Lösung der genannten Aufgabe wird ein Prüfkopf mit den Merkmalen des Anspruchs 1 vorgeschlagen. Dieser zeichnet sich dadurch aus, daß die Kontaktelemente in der jeweils zugeordneten Durchgangsöffnung der Führungsplatten axial verschlieblich geführt sind und daß die jeweils einem Kontaktelement zugeordneten Durchgangsöffnungen der Führungsplatten derart versetzt zueinander angeordnet sind, daß das Kontaktelement in ihnen oder in mindestens einer von ihnen reibschlüssig gehalten ist. Die durch den Reibschluß zwischen der beziehungsweise den Durchgangsöffnungen und dem darin angeordneten Kontaktelement auf dieses wirkende Haltekräfte sind derart hoch, daß in einer Bereitschaftsstellung des Prüfkopfs, also wenn die Kontaktelemente nicht an den Prüfpunkten eines Prüflings anliegen, die Kontaktelemente in der beziehungsweise in den Durchgangsöffnungen gehalten wird. Ein Herausfallen der Kontaktelemente aus dem Prüfkopf aufgrund ihres Eigengewichts wird somit sicher verhindert. Die durch den Reibschluß auf die Kontaktelemente wirkenden Haltekräfte sind gleichzeitig aber auch so gering, daß bei einem Prüfvorgang die Kontaktelemente in axialer Richtung verlagert werden können. Dabei knicken und/oder federn die Kontaktelemente in dem Zwischenraum zwischen den Führungsplatten senkrecht oder im wesentlichen senkrecht zu ihrer Längserstreckung aus, wodurch die Kontaktkraft aufgebracht wird. Die Kontaktelemente des Prüfkopfs können eng, also in einem vorzugsweise sehr geringen Abstand nebeneinander angeordnet werden, so daß auch Prüflinge auf Funktion geprüft werden können, deren Prüfpunkte klein und auf engstem Raum angeordnet sind. Auf eine Vergrößerung des Durchmessers der Kontaktelemente, um diese am Prüfkopf, das heißt in den Durchgangsöffnungen der Führungsplatten zu halten, kann also verzichtet werden. Ein weiterer Vorteil, der sich durch das reibschlüssige Halten der Kontaktelemente ergibt, besteht darin, daß diese servicefreundlich montierbar sind, das heißt, sie können sowohl einfach in den Prüfkopf eingebracht als auch im Bedarfsfall ausgetauscht werden. Hierzu muß das jeweilige Kontaktelement lediglich aus den Durchgangsöffnungen der Führungsplatten herausgezogen beziehungsweise hindurchgedrückt werden.

Es ist eine dritte Führungsplatte vorgesehen, die im Zwischenraum zwischen einer ersten Führungsplatte und einer zweiten Führungsplatte der Konaktiervorrichtung angeordnet ist, wobei mindestens eine der einem Kontaktelement zugeordneten Durchgangsöffnungen zu den anderen Durchgangsöffnungen in den anderen Führungsplatten versetzt ist. Vorzugsweise. ist die Durchgangsöffnung der dritten Führungsplatte zu den Durchgangsöffnungen der ersten und zweiten Führungsplatte versetzt angeordnet, so daß die Kontaktelemente bei zusammengebautem Prüfkopf definiert vorgebogen sind. Dadurch werden einerseits die Knickkraft vollständig ausgeschaltet und andererseits der Reibschluß zwischen den Kontaktelementen und mit jeweils mindestens einer zugeordneten Durchgangsöffnung der Führungsplatten gebildet. Durch die dritte Führungsplatte wird ferner sichergestellt, daß die Kontaktelemente sich insbesondere während eines Prüfvorgangs nicht gegenseitig berühren, so daß gegebenenfalls auf eine elektrische Isolierung der Kontaktelemente gegeneinander hin verzichtet werden kann, was die Kosten des Prüfkopfs reduziert.

Bevorzugt wird auch ein Ausführungsbeispiel des Prüfkopfs, bei dem das den Prüfpunkten zugewandte und/oder abgewandte freie Ende der Kontaktelemente eine Kontaktspitze aufweist. Dadurch können auch sehr kleine, eng nebeneinander angeordnete Prüfpunkte kontaktiert werden. Aufgrund der geringen Anlagefläche der Kontaktspitze an einem Prüfpunkt ist die sich einstellende Flächenpressung relativ groß, so daß ein guter elektrischer Kontakt gebildet wird. Nach einer ersten Ausführungsvariante ist vorgesehen, daß die stiftförmigen, vorzugsweise aus einem federelastischen Material bestehenden Kontaktelemente an einem freien Ende oder an beiden freien Enden zur Ausbildung der Kontaktspitze spitz zulaufen beziehungsweise angespitzt sind. Das jeweilige Kontaktelement und die Kontaktspitze sind also einstückig ausgebildet. Bei einem anderen Ausführungsbeispiel ist die Kontaktspitze ein separates Teil, das am freien Ende der Kontaktelemente angebracht wird. Dadurch können individuell für jeden Prüfkopf Kontaktelemente eingesetzt werden, die Kontaktspitzen mit unterschiedlichen Formen und/oder Größen aufweisen, was die Anpassungsfähigkeit des Prüfkopfs verbessert. Unabhängig von der Ausgestaltung der Kontaktspitze kann deren größter Durchmesser beziehungsweise größte Breite kleiner oder größer als der Durchmesser des Kontaktelements sein oder aber diesem entsprechen. Das heißt, der Übergang vom Kontaktelement zur Kontaktspitze ist entweder fließend und stufenlos oder aber der Übergang weist mindestens einen Absatz auf.

Weitere vorteilhafte Ausführungsformen ergeben sich aus den übrigen Unteransprüchen.

Die Erfindung wird im folgenden anhand der Zeichnung näher erläutert. Es zeigen:
- Figur 1: eine Prinzipskizze eines ersten Ausführungsbeispiels des erfindungsgemäßen Prüfkopfs und
- Figur 2: eine Prinzipskizze eines weiteren Ausführungsbeispiels des Prüfkopfs.

Der im folgenden beschriebene Prüfkopf dient zur Prüfung elektronischer Bauelemente, deren Prüfpunkte klein und nebeneinander angeordnet sind. Der Prüfkopf ist allgemein einsetzbar, beispielsweise im Bereich der Halbleitertechnik für den elektrischen Test von Feinstleiterplatten und Halbleiterwafern.

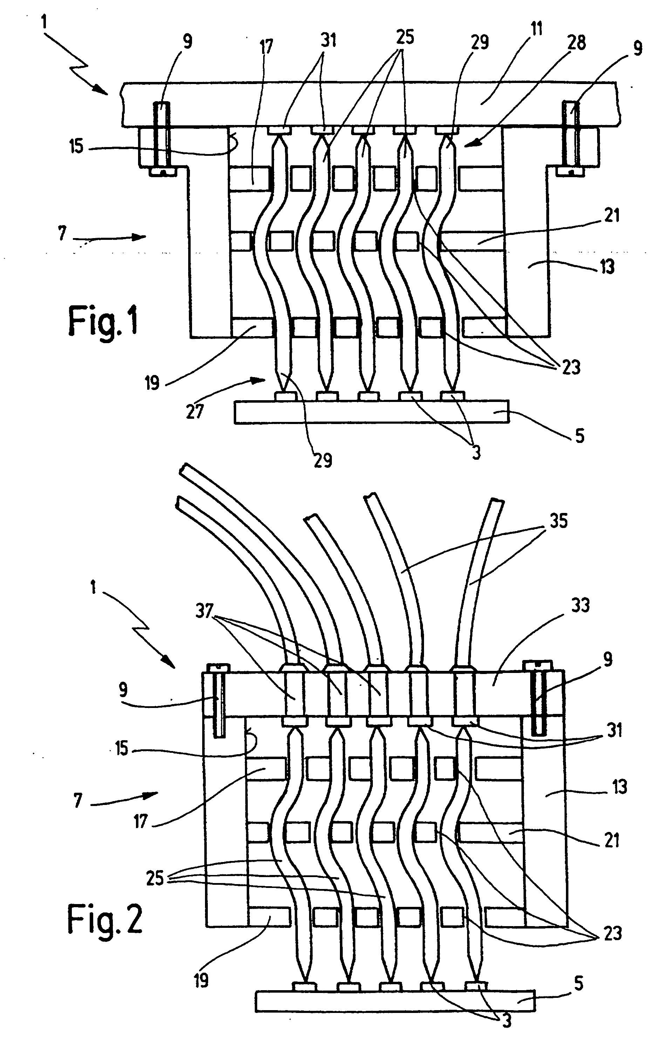

Figur 1 zeigt schematisch einen Ausschnitt eines ersten Ausführungsbeispiels eines Prüfkopfs 1 zum gleichzeitigen Kontaktieren von mehreren, nebeneinander angeordneten Prüfpunkten 3 eines elektrischen Prüflings 5. Der Prüfkopf 1 umfaßt eine Kontaktiervorrichtung 7, die mittels Befestigungsmittel 9, beispielsweise Schrauben, lösbar mit einer Leiterplatte 11 einer Prüfeinheit verbunden ist. Die Prüfeinheit ist wiederum mit einer Prüfeinrichtung, beispielsweise einer Prüfspannungsquelle oder dergleichen verbunden.

Die Kontaktiervorrichtung 7 umfaßt einen hülsenförmigen Grundkörper 13, der ein Durchgangsloch 15 aufweist, in dem eine erste Führungsplatte 17, eine zweite Führungsplatte 19 und eine dritte Führungsplatte 21 parallel zueinander und in einem Abstand voneinander gehalten sind. In den Führungsplatten 17, 19, 21 sind Durchgangsöffnungen 23 eingebracht, in denen stiftförmige, auch als Testsonden bezeichnete Kontaktelemente 25 axial verschieblich geführt sind. Die Kontaktelemente 25 bestehen aus einem elastischen, vorzugsweise federelastischen Material, zum Beispiel Federmetall, und sind hier als Knickdrähte ausgebildet. Die Führungsplatten 17, 19, 21 bestehen vorzugsweise aus einem elektrisch nicht-leitenden Material, beispielsweise einem Kunststoff, Glas, Keramik, Silizium oder dergleichen.

Wie aus Figur 1 ersichtlich, sind die jeweils einem Kontaktelement 25 zugeordneten Durchgangsöffnungen 23 der ersten und zweiten Führungsplatte 17 beziehungsweise 19 fluchtend miteinander angeordnet. Die zugeordnete Durchgangsöffnung 23 der in dem Zwischenraum zwischen der ersten und zweiten Führungsplatte angeordneten dritten Führungsplatte 21 ist zu den Durchgangsöffnungen 23 der Führungsplatten 17, 19 versetzt. Dadurch weisen die in den Durchgangsöffnungen 23 angeordneten Kontaktelemente 25 einen Bogen auf. Durch das Auslenken der Kontaktelemente 25 senkrecht zu deren Längserstreckung wird ein Reibschluß zwischen den Kontaktelementen 25 und mindestens einer der zugeordneten Durchgangsöffnungen 23 der Führungsplatten 17, 19, 21 gebildet. Die Kontaktelemente 25 werden ausschließlich durch Reibung im Grundkörper 13 der Kontaktiervorrichtung 7 gehalten. Ein Herausfallen beziehungsweise Herausgleiten der Kontaktelemente 25 aus den Durchgangsöffnungen 23 wird somit sicher verhindert.

Die Kontaktelemente 25 weisen an ihrem den Prüfpunkten 3 des Prüflings 5 zugewandten freien Ende 27 und an ihrem der Leiterplatte 11 zugewandten freien Ende 28 jeweils eine Kontaktspitze 29 auf, die durch Anspitzen der stiftförmigen Kontaktelemente 25 gebildet wird. Die Kontaktelemente 25 sind mit ihrem den Prüfpunkten 3 abgewandten freien Ende 28 an jeweils eine zugeordnete Kontaktstelle 31 andrückbar, die bei dem in Figur 1 dargestellten Ausführungsbeispiel auf der Leiterplatte 11 der Prüfeinheit angebracht sind. Das freie Ende 27 der Kontaktelemente 25 ist an jeweils einen zugeordneten Prüfpunkt 3 des Prüflings 5 andrückbar.

Im folgenden wird die Funktion des Prüfkopfs 1 anhand eines Prüfvorgangs näher erläutert: In der in Figur 1 dargestellten Funktionsstellung der Kontaktiervorrichtung 7 berühren die Kontaktelemente 25 sowohl die Prüfpunkte 3 des Prüflings 5 als auch die Kontaktstellen 31 auf der Leiterplatte 11. Durch eine Relativbewegung zwischen der Kontaktiervorrichtung 7 und dem Prüfling 5 werden die Kontaktelemente 25 in den Durchgangsöffnungen 23 der Führungsplatten 19 und 21 axial verlagert. Durch die Druckbeaufschlagung der stiftförmigen Kontaktelemente 25 in Längsrichtung werden die durch die versetzte Anordnung der Durchgangsöffnungen der' dritten Führungsplatte 21 bereits vorgebogenen Kontaktelemente 25 ausgelenkt. Die durch die elastischen Eigenschaften des Materials der Kontaktelemente erzeugten Rückstellkräfte pressen dabei die Kontaktelemente 25 mit ihren Kontaktspitzen 29 definiert an die Prüfpunkte 3 des Prüflings 5 und an die Kontaktstellen 31 der Leiterplatte 21, wodurch ein geringer elektrischer Kontaktwiderstand erzielt wird. Die Prüfpunkte 3 können nun auf Durchgang und Isolation gegeneinander hin beziehungsweise der Prüfling 5 auf Funktion überprüft werden. Nachdem der Prüfvorgang abgeschlossen ist, werden die Kontaktiervorrichtung 7 und der Prüfling 5 voneinander getrennt. Die ausgelenkten/durchgebogenen Kontaktelemente 25 verlagern sich nun aufgrund ihrer elastischen Eigenschaften selbsttätig in ihre Ausgangsstellung zurück.

Es wird deutlich, daß die Kontaktstellen 31 auf der Leiterplatte 11 als Widerlager für die Kontaktelemente 25 dienen. Es ist bei einem nicht dargestellten Ausführungsbeispiel des Prüfkopfs vorgesehen, daß die Kontaktelemente 25 in Bereitschaftsstellung des Prüfkopfs 1 zu den Kontaktstellen 31 beabstandet angeordnet sind. Dadurch werden beim Kontaktieren der Prüfpunkte die Kontaktelemente 25 zunächst soweit axial verlagert, bis diese an den Kontaktstellen 31 anliegen. Erst dann können die Kontaktelemente 25 weiter durchgebogen und somit die Kontaktkräfte erzeugt werden, die die Kontaktspitzen 29 der Kontaktelemente 25 an den jeweiligen Prüfpunkt 3 beziehungsweise die jeweilige Kontaktstelle 31 anpressen.

Das in Figur 1 dargestellte Ausführungsbeispiel des Prüfkopfs 1 zeichnet sich durch eine sehr kompakte Bauweise und eine hohe Anpassungsfähigkeit an beispielsweise verschiedene Prüflinge und/oder Prüfparameter aus.

Figur 2 zeigt schematisch ein weiteres Ausführungsbeispiel des Prüfkopfs 1. Teile, die mit denen in Figur 1 übereinstimmen, sind mit gleichen Bezugszeichen versehen, daß insofern auf die Beschreibung zur Figur 1 verwiesen wird. Im folgenden soll lediglich auf die Unterschiede näher eingegangen werden.

Die Kontaktiervorrichtung 7 ist mittels der Befestigungsmittel 9 lösbar mit einem Anschlußkopf 33 verbunden, an dem die Kontaktstellen 31 angebracht sind. Diese sind jeweils mit dem freien Ende einer Leitung 35 verbunden, die über nicht dargestellte Steckverbinder oder direkt mit der Prüfeinrichtung verbunden sind. Die Leitungen 35 sind in Löchern 37 des Anschlußkopfs 33 befestigt, beispielsweise eingeklebt.

Den in den Figuren 1 und 2 dargestellten Ausführungsbeispielen ist gemeinsam, daß die Kontaktiervorrichtung 7 einfach durch Lösen der Befestigungsmittel 9 von den übrigen Teilen des Prüfkopfs 1 getrennt werden kann. Die Kontaktelemente 25 sind dann von beiden Öffnungen des Durchgangslochs 15 zugänglich, was einen Austausch einzelner Kontaktelemente 25 vereinfacht. Dadurch, daß die Kontaktelemente 25 lediglich reibschlüssig in wenigstens einer der Durchgangsöffnungen 23 der Führungsplatten 17, 19, 21 gehalten sind, können diese ohne weiteres aus den Durchgangsöffnungen ausgebracht und neue Kontaktelemente eingesetzt werden.

Zusammenfassend ist festzuhalten, daß der anhand der Figuren 1 und 2 beschriebene Prüfkopf 1 einen einfachen Aufbau aufweist und somit kostengünstig herstellbar ist, insbesondere deshalb, weil die Kontaktelemente lediglich reibschlüssig in den Durchgangsöffnungen der Führungsplatten beziehungsweise in der Durchgangsöffnungen einer der Führungsplatten reibschlüssig gehalten sind. Mit dem Prüfkopf können fein strukturierte Prüflinge, deren Prüfpunkte sehr klein und in einem geringen Abstand voneinander angeordnet sind, geprüft werden, wobei durch die angespitzten Kontaktelemente beziehungsweise die Kontaktspitzen der Kontaktelemente -aufgrund der hohen Flächenpressung- ein guter elektrischer Kontakt sowohl zwischen Kontaktelement und Prüfpunkt als auch Kontaktelement und Kontaktstelle erreicht wird.

## Patentansprüche

1. Prüfkopf (1) mit einer mehrere Kontaktelemente (25) aufweisenden Kontaktiervorrichtung (7) zum Kontaktieren von vorzugsweise eng nebeneinander angeordneten Prüfpunkten (3) eines elektrischen Prüflings, wobei die Kontaktelemente mit einer Prüfeinheit, insbesondere mit einer Leiterplatte (11) der Prüfeinheit einer Prüfeinrichtung elektrisch verbindbar sind, aus einem elastischen, vorzugsweise federelastischen Material bestehen und in Durchgangsöffnungen (23) von mindestens drei Führungsplatten (17,19,21) angeordnet sind, wobei die Führungsplatten (17,19,21) in einem Abstand voneinander angeordnet sind, wobei sich eine dritte Führungsplatte (21) im Zwischenraum zwischen einer ersten Führungsplatte (17) und einer zweiten Führungsplatte (19) befindet, und wobei die Kontaktelemente (25) in der jeweils zugeordneten Durchgangsöffnung (23) der Führungsplatten (17,19,21) axial verschieblich geführt und die jeweils einem Kontaktelement (25) zugeordneten Durchgangsöffnungen (23) der Führungsplatten (17,19,21) derart versetzt zueinander angeordnet sind, dass das Kontaktelement (25) durch bogenförmige Auslenkung in ihnen reibschlüssig gehalten werden, **dadurch gekennzeichnet, daß** die Kontaktelemente für ein Einbringen und einen Austausch in die Durchgangsöffnungen einfach (23) einsteckbar beziehungsweise aus diesen herausziehbar sind.

2. Prüfkopf nach Anspruch 1, **dadurch gekennzeichnet, daß** die jeweils einem Kontaktelement (25) zugeordneten Durchgangsöffnungen (23) der ersten und zweiten Führungsplatte (17,19) fluchtend angeordnet sind und daß die zugeordnete Durchgangsöffnung (23) in der dritten Führungsplatte (21) zu den Durchgangsöffnungen (23) der anderen Führungsplatten (17,19) versetzt ist.

3. Prüfkopf nach einem der vorhergehenden Ansprüche, **dadurch gekennzeichnet, daß** die Kontaktelemente (25) als Knickdrähte ausgebildet sind.

4. Prüfkopf nach einem der vorhergehenden Ansprüche, **dadurch gekennzeichnet, daß** das den Prüfpunkten (3) zugewandte (27) und/oder abgewandte (28) freie Ende der Kontaktelemente (25) eine Kontaktspitze (29) aufweisen/aufweist.

5. Prüfkopf nach einem der vorhergehenden Ansprüche, **dadurch gekennzeichnet, daß** das den Prüfpunkten (3) zugewandte Ende (27) der Kontaktelemente (25) an den jeweils zugeordneten Prüfpunkt (3) andrückbar ist.

6. Prüfkopf nach einem der vorhergehenden Ansprüche, **dadurch gekennzeichnet, daß** das den Prüfpunkten (3) abgewandte freie Ende (28) der Kontaktelemente (25) zur Herstellung des elektrischen Kontakts mit der Prüfeinheit an jeweils eine zugeordnete Kontaktstelle (31) andrückbar ist.

7. Prüfkopf nach Anspruch 6, **dadurch gekennzeichnet, daß** die Kontaktstelle (31) auf der Prüfeinheit angebracht ist.

8. Prüfkopf nach Anspruch 6 oder 7, **dadurch gekennzeichnet, daß** die Kontaktstelle (31) mit dem freien Ende einer Leitung (35) verbunden ist, die zur Prüfeinrichtung führt.

## Claims

1. Probe (1) with a contact device (7) comprising several contact elements (25) for contacting probing points (3), which are preferably arranged in close proximity to each other, of an electrical test piece, in which the contact elements can be electrically connected to a test unit, in particular to a printed circuit board (11) of the test unit of a test device, made from a springy, preferably elastic material and arranged in feed-through openings (23) of at least three guide plates (17, 19, 21), where the guide plates (17, 19, 21) are arranged at a distance from each other, where a third guide plate (21) is located in the interval between a first guide plate (17) and a second guide plate (19), and where the contact elements (25) are guided so as to be axially displaceable into the respective assigned feed-through opening (23) of the guide plates (17, 19, 21) and the feed-through openings (23) of the guide plates (17, 19, 21) respectively assigned to a contact element (25) are arranged offset from each other in such a way that the contact element (25) is frictionally engaged within them due to curvilinear deflection, **characterised in that** the contact elements can, for insertion and exchange purposes, easily be inserted into or removed from the feed-through openings (23).

2. Probe according to claim 1, **characterised in that** the feed-through openings (23) respectively assigned to a contact element (25) of the first and second guide plate (17, 19) are arranged in alignment and that the assigned feed-through opening (23) in the third guide plate (21) is offset with respect to the feed-through openings (23) of the other guide plates (17, 19).

3. Probe according to one of the preceding claims **characterised in that** the contact elements (25) are designed as buckling wires.

4. Probe according to one of the preceding claims, **characterised in that** the free end of the contact elements (25) facing towards (27) and/or facing away (28) from the probing points (3) comprise(s) a contact tip (29).

5. Probe according to one of the preceding claims **characterised in that** the end (27) of the contact element (25) turned towards the probing points (3) can be pressed against the respectively assigned probing point (3).

6. Probe according to one of the preceding claims, **characterised in that** the free end (28) of the contact element (25) turned away from the probing points (3), in order to create electrical contact with the test unit, can be pressed against a respectively assigned contact point (31).

7. Probe according to claim 6, **characterised in that** the contact point (31) is attached to the test unit.

8. Probe according to claim 6 or 7, **characterised in that** the contact point (31) is connected to the free end of a conductor (35) which leads to the test device.

## Revendications

1. Tête de sonde (1) comprenant un dispositif de contact (7) présentant plusieurs éléments de contact (25) pour entrer en contact avec des points de contrôle (3) de préférence disposés à proximité les uns des autres d'un objet électrique à tester, les éléments de contact pouvant être reliés électriquement avec une unité de contrôle, en particulier avec une carte à circuit imprimé (11) de l'unité de contrôle d'un appareil de contrôle, étant constitués d'un matériau élastique, de préférence à élasticité de ressort, et étant disposés dans des orifices de passage (23) d'au moins trois plaques de guidage (17, 19, 21), les plaques de guidage (17, 19, 21) étant disposées à distance les unes des autres, une troisième plaque de guidage (21) se trouvant dans l'intervalle entre une première plaque de guidage (17) et une deuxième plaque de guidage (19), et les éléments de contact (25) étant guidés de manière coulissante axialement dans les orifices de passage (23) respectives associées des plaques de guidage (17, 19, 21), les orifices de passage (23) des plaques de guidage (17, 19, 21) associées à un élément de contact (25) respectif étant disposées en déport les unes par rapport aux autres, de telle sorte que ledit élément de contact (25) est maintenu par friction dans celles-ci par une déformation en forme d'arc, **caractérisée en ce que** les éléments de contact peuvent être facilement insérés dans les ouvertures de passage (23) et extraits de celles-ci pour un montage et un remplacement.

2. Tête de sonde selon la revendication 1, **caractérisée en ce que** les ouvertures de passage (23) des première et deuxième plaques de guidage (17, 19) associées à un élément de contact respectif (25) sont disposées en alignement et **en ce que** l'orifice de passage (23) associée dans la troisième plaque de guidage (21) est en déport par rapport aux orifices de passage (23) des autres plaques de guidage (17, 19).

3. Tête de sonde selon l'une quelconque des revendications précédentes, **caractérisée en ce que** les éléments de contact (25) sont configurés comme des fils coudés.

4. Tête de sonde selon l'une quelconque des revendications précédentes, **caractérisée en ce que** l'extrémité libre des éléments de contact (25) orientée vers (27) et/ou opposée (28) aux points de contrôle (3) présente(nt) une pointe de contact (29).

5. Tête de sonde selon l'une quelconque des revendications précédentes, **caractérisée en ce que** l'extrémité (27) des éléments de contact (25) orientée vers les points de contrôle (3) peut être appliquée par pression sur le point de contrôle (3) correspondant.

6. Tête de sonde selon l'une quelconque des revendications précédentes, **caractérisée en ce que** l'extrémité libre (28) des éléments de contact (25) opposée aux points de contrôle (3) peut être appliquée par pression sur un point de contact (31) respectif associé pour établir le contact électrique avec l'unité de contrôle.

7. Tête de sonde selon la revendication 6, **caractérisée en ce que** le point de contact (31) est monté sur l'unité de contrôle.

8. Tête de sonde selon la revendication 6 ou 7, **caractérisée en ce que** le point de contact (31) est relié avec l'extrémité libre d'une ligne (35) qui mène à l'appareil de contrôle.
